# EUROPEAN PATENT APPLICATION

(11) **EP 4 560 271 A1**
(43) Date of publication of application: **28.05.2025**
(21) Application number: 23211827.3
(22) Date of filing: 23.11.2023
(51) Int. Cl.: G01D 5/244, G01D 5/347, H02K 41/03

(54) **MAGNETIC TRACK BASE FOR A STATIONARY PART OF A LINEAR MOTOR**

(71) Applicant: ETEL S.A., 2112 Môtiers (CH)
(72) Inventor: Tamigniaux, Philippe, 25500 Morteau (FR); Droval, Yannick, 2000 Neuchâtel (FR)
(74) Representative: P&TS SA (AG, Ltd.)

(57) **Abstract**

The invention relates to a magnetic track base (20) for a stationary part (10) of a linear motor, comprising a magnetic receiving portion (22) configured to fixedly receive permanent magnets (52), rail receiving portions (26) configured to fixedly receive rails (50) along both sides of the magnets receiving portion (22) and an encoder scale support receiving portion (30) configured to fixedly receive an encoder scale support (40). The encoder scale support receiving portion comprises a plurality of decoupled tabs (31) mechanically decoupled from the rest of the magnetic track base (20) and arranged to receive a bottom side of the encoder scale support (40) to prevent, or at least reduce, deformation of the encoder scale support receiving portion (30) that may be caused from the deformation of the rest of the magnetic track base (20) when said track base (20) is subjected to external forces.

## Description

### Field of the invention

The present invention relates to a magnetic track base for a stationary part of a linear motor. The invention also relates to a motion-positioning system, in particular a wafer positioning system, comprising at least one linear motor with its stationary part comprising the magnetic track base.

### Background of the invention

X-Y motion-positioning systems require high precision linear encoders to provide accurate positioning. Encoder scales must therefore remain as stable as possible while withstanding external disturbances to avoid a loss of accuracy.

Encoder scale supports are generally screwed onto a magnetic track base together with other elements such as mechanical bearing rails, and magnets of the magnetic track, without any particular design care on the magnetic track base. In most cases, the scale and the carrier consist of materials with different thermal expansion behavior. The stationary fixation must therefore be designed in such a way that no constraining forces are exerted on the scale by the carrier when the temperature changes.

Some encoder scale support geometry such as disclosed in EP 3705850 can be quite insensitive to some perturbations by adding to it decoupling devices such as hinge and leaf. This solution is however rather complex to implement and therefore expensive.

### Brief summary of the invention

An aim of the present invention is therefore to provide a magnetic track base for a stationary part of a linear motor, which is exempt of the above limitations.

More particularly, an aim of the present invention is to provide a magnetic track base comprising an encoder scale support receiving portion which does not deform when subjected to external forces, or at least in a lesser magnitude than a conventional scale support.

Another aim of the present invention is to provide a magnetic track base that is easy to produce and cost-effective.

These aims are achieved notably by a magnetic track base for a stationary part of a linear motor, comprising a magnetic receiving portion configured to fixedly receive permanent magnets, rail receiving portions configured to fixedly receive rails along both sides of the magnets receiving portion and an encoder scale support receiving portion configured to fixedly receive an encoder scale support. The encoder scale support receiving portion comprises a plurality of decoupled tabs mechanically decoupled from the rest of the magnetic track base and arranged to receive a bottom side of the encoder scale support to prevent, or at least reduce, deformation of the encoder scale support receiving portion that may be caused from the deformation of the rest of the magnetic track base when said track base is subjected to external forces.

In an embodiment, the plurality of decoupled tabs comprises a corresponding plurality of fixation tabs and decoupling members for mechanical decoupling between each fixation tab and the rest of the magnetic track base.

In an embodiment, each decoupling member is a cut-out part arranged around a corresponding fixation tab.

In an embodiment, each cut-out part is in the form of a U-shape through-groove extending from a top side to a bottom side of the magnetic track base.

In an embodiment, each fixation tab comprises a top flat surface comprising a fixation hole. The surface is raised above the surface of the magnetic receiving portion.

In an embodiment, the plurality of fixation tabs is arranged along a longitudinal direction between the magnetic receiving portion and one rail receiving portion.

In an embodiment, the magnetic receiving portion comprises a plurality of pairs of threaded holes for fixing permanent magnets with screws and a plurality of pairs of through-holes for fixing the magnetic track base to a magnetic track base support.

In an embodiment, the cut-out parts each surrounds one through-hole of said pairs of through-holes for fixing the magnetic track base to the magnetic track base support in such a way that the fixation tabs are rigidly fixed to said support.

In an embodiment, the magnetic track base is monobloc.

In an embodiment, the encoder scale support has a predominantly constant L-shaped cross-section along its length forming a stand which is fixed onto the encoder scale support receiving portion.

Another aspect of the invention relates to a stationary part of a linear motor. The stationary part comprises the magnetic track base according to any of the above-described embodiments, magnets fixed to the magnetic receiving portion, rails fixed on rail receiving portions on both sides of the magnets, an encoder scale support fixed to the encoder scale support receiving portion and an encoder scale fixed to the encoder scale support.

Another aspect of the invention relates to a linear motor comprising the above-described stationary part and a mobile part comprising a coil assembly, sliders slidably engaged with respective rails of the stationary part and an optical reader arranged to move along the encoder scale.

A further aspect of the invention relates to a motion-positioning system, in particular a wafer positioning system, comprising at least one of the above-described linear motor.

### Brief description of the drawings

The invention will be better understood with the aid of the description of embodiments given by way of examples and illustrated by the figures, in which:
- Figure 1 shows a perspective view of the magnetic track base according to an embodiment;
- Figure 2 shows an enlarged view of one of the plurality of fixation tabs of Figure 1;
- Figure 3 shows a perspective view of the encoder scale support designed to be fixed to the encoder scale support receiving portion of the magnetic track base of Figure 1;
- Figures 4a shows a simulation of the magnetic track comprising the encoder scale support when exposed to external force of 5000 [N] with the deformation of the part amplified twenty thousand times;
- Figure 4b shows a simulation of the encoder scale support of Figure 4a with the deformation of the scale support amplified a hundred thousand times;
- Figures 5a shows a simulation of a conventional magnetic track comprising the encoder scale support when exposed to external force of 5000 [N] with the part subjected to deformation amplified twenty thousand times;
- Figure 5b shows a simulation of the encoder scale support of Figure 5a with the deformation of the scale support amplified a hundred thousand times;
- Figure 6 shows a perspective view of a wafer positioning system comprising a motion system consisting of x and y linear motors comprising both the magnetic track base according to an embodiment;
- Figure 7 shows a perspective view of the motion system of the wafer positioning system of Figure 6 with some parts hidden to highlight the encoder scale support, and
- Figure 8 shows a side view of the motion system of Figure 6.

### Detailed description of several embodiments of the invention

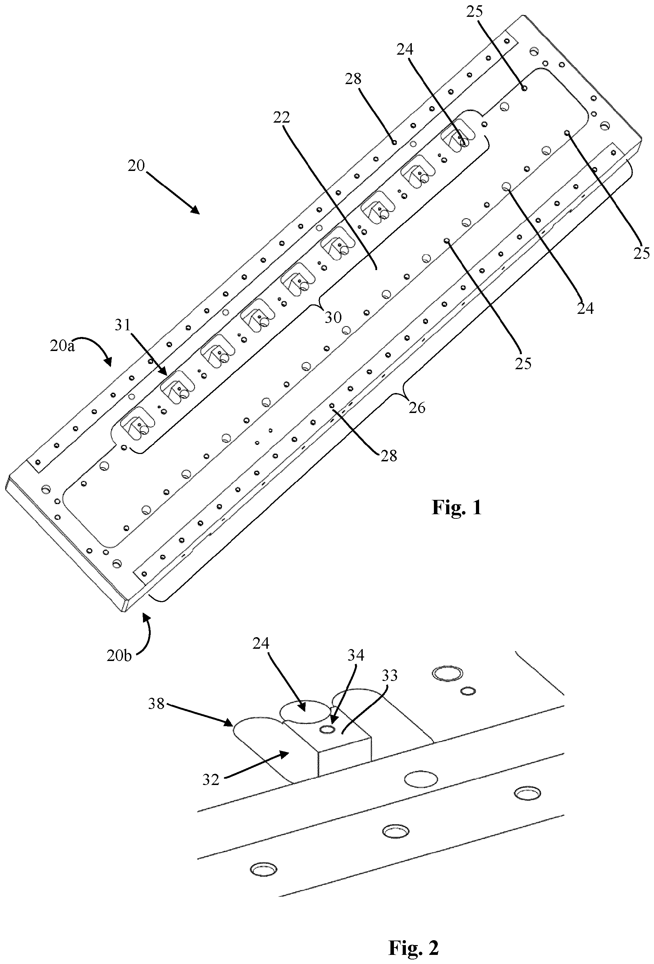

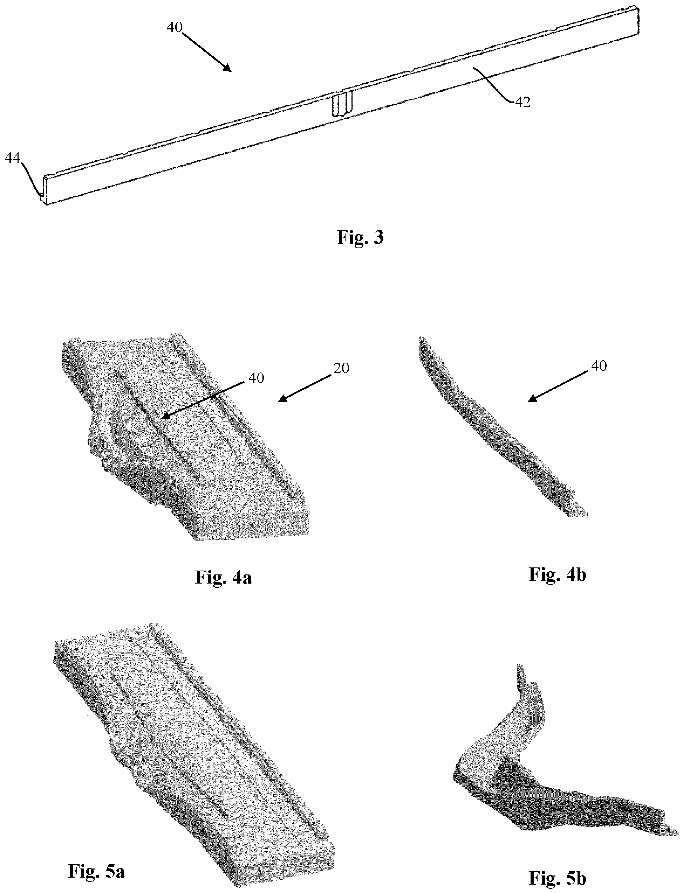

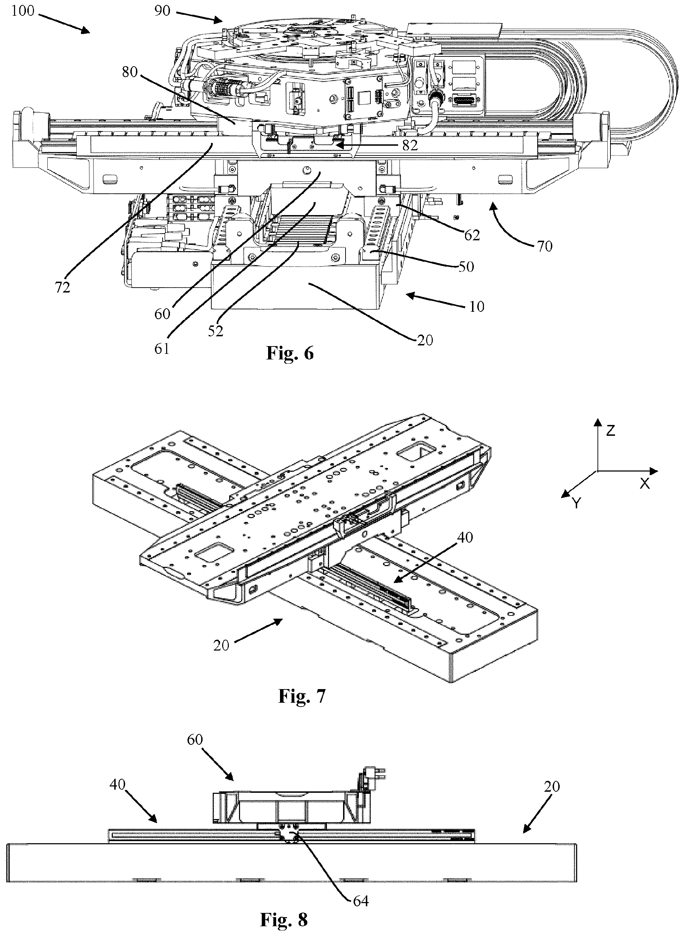

With reference to Figure 1, the magnetic track base 20 is specifically designed to support the encoder scale support 40 of Figure 3 with no or minimal deformation of the scale support 40 when subjected to external forces. The magnetic track base 20 is designed to be integrated in a stationary part 10 of a linear motor of a motion-positioning system, in particular a wafer positioning system 100 as shown in Figures 6 to 8.

The magnetic track base 20 is configured to support permanent magnets 52 and rails 50 which are slidably engaged with sliders 62 of a movable part 60 comprising a coil assembly 61. The coil assembly comprises a set of electromagnetic coils that are wrapped around an iron core and adapted to be sequentially energized to displace the movable part 60 above and along the magnetic track made of the permanent magnets 52.

The aforementioned external forces are of different natures such as the attraction forces between the magnets and the iron core of the movable part, thermal stress induced by the differential thermal expansion between the rails 50 and the magnetic track base 20 and mechanical strain in the rails induced by non-perfect alignment between the rails 50 and the sliders 62 of respective stationary and movable parts 10, 60.

The magnetic track base 20 comprises a magnetic receiving portion 22 configured to fixedly receive permanent magnets 52, rail receiving portions 26 configured to fixedly receive rails 50 along both sides of the magnetic receiving portion 22 and an encoder scale support receiving portion 30 configured to fixedly receive the encoder scale support 40. The magnetic receiving portion 22 comprises a plurality of pairs of threaded holes 25 for fixing permanent magnets 52 with screws and a plurality of pairs of through-holes 24 for fixing the magnetic track base 20 to a support (not shown).

The encoder scale support receiving portion 30 comprises a plurality of decoupled tabs 31 mechanically decoupled from the rest of the magnetic track base 20. In the illustrated embodiment, the plurality of decoupled tabs 31 comprises fixation tabs 32 arranged along a longitudinal direction between the magnetic receiving portion 22 and one rail receiving portion 26 of the magnetic track base 20. A corresponding plurality of decoupling members 38 are arranged around each fixation tabs 32 for mechanical decoupling between each fixation tab 32 and a longitudinal side of the magnetic track base 20. The decoupling members 38 may be for example cut-out parts 38 that are each arranged around respective fixation tab 32 and surrounding a through-hole 24 in such a way that the fixation tabs 32 are rigidly fixed to the magnetic track base support.

Referring to Figure 2, each fixation tab 32 comprises a top flat surface 33 which is raised above the surface of the magnetic receiving portion 22 such that the encoder scale support 40 is distant and elevated from the magnets receiving portion 22. Each cut-out part 38 is in the form of a U-shaped through-groove extending from a top side 20a to a bottom side 20b of the magnetic track base 20. Fillets are foreseen so that the groove can be easily milled in the base.

Referring to Figure 3, the encoder scale support 40 has a predominantly constant L-shaped cross-section along its length forming a stand 44 which is fixed onto the encoder scale support receiving portion 30 and a scale receiving side 42 on which is fixed an encoder scale (not shown). The scale receiving side 42 can comprise some grooves for gluing the encoder scale at its reference point. The top flat surface 33 of the fixation tabs 32 may comprise a fixation hole 34 to screw the stand 44 of the encoder scale support 40 onto the encoder scale support receiving portion 30.

The cut-out parts 38 of the encoder scale support receiving portion 30 onto which is fixed the encoder scale support 40 allow to mechanically decouple the scale support 40 from the rest of the magnetic track base 20. As a consequence, deformation of the magnetic track base 20 induced by external forces, as those mentioned above, does not negatively impact the shape of the encoder scale support receiving portion 30, or at least in a lesser magnitude than conventional scale support receiving portions. Thus, the deformation of encoder scale support 40 does not occur or within an acceptable range for high-precision positioning.

The magnetic track base 20 is a monolithic piece generally made of aluminum and is obtained by a milling process.

With reference to Figure 4a to 5b, one can see that the encoder scale support of the magnetic track base, according to the embodiment illustrated in Figure 1, is much less impacted by the deformation of the rest of the magnetic track base as opposed to a conventional magnetic track base. Indeed, the encoder scale support deformation is decreased by more than fivefold in comparison with a conventional magnetic track without mechanical decoupling. The immunity improvement is also valid for other mechanical bearing perturbations. For example, when using recirculating ball or roller bearings for the sliders 62, the balls or rollers circulate, moving from the return zone to the load-carrying zone. This can create a periodic force perturbation from which the encoder scale support must be decoupled.

The wafer positioning system 100 illustrated in Figures 6 to 8 comprises a first linear motor as described previously and a second linear motor comprising a stationary part 70 mounted on the moveable part 60 of the first linear motor, the moveable part 60 being equipped with an optical position sensor unit 64 arranged to move along the encoder scale so as to be positioned precisely along the X-axis of the coordinates system of the wafer positioning system 100. The stationary part 70 of the second linear motor also comprises an encoder scale support 72 on which is fixed an encoder scale (not shown). A wafer stage 90 is mounted on moveable part 80 of the second linear motor, the moveable part 80 being equipped with an optical position sensor unit 82 arranged to move along the encoder scale so as to be positioned precisely along the Y-axis of the coordinates system of the wafer positioning system 100.

### Reference list

Stationary part 10
   Magnetic track base 20
      Top side 20a
      Bottom side 20b
      Magnets receiving portion 22
         First set of fixation holes 24
         Second set of fixation holes 25
      Rail receiving portion 26
         Fixation holes 28
      Encoder scale support receiving portion 30
         Decoupled tabs 31
         Fixation tabs 32
         Flat surfaces 33
         Holes 34
         Decoupling members 38 (e.g. Cut-out parts)
Encoder scale support 40
   Scale receiving side 42
   Stand 44
Rails 50
Magnets 52
Movable part 60
   Coil assembly 61
   Sliders 62
   Optical position sensor unit 64
Stationary part 70
   Encoder scale support 72
Movable part 80
   Optical position sensor unit 82
Wafer stage 90
Wafer positioning system 100

## Claims

1. Magnetic track base (20) for a stationary part (10) of a linear motor, comprising a magnetic receiving portion (22) configured to fixedly receive permanent magnets (52), rail receiving portions (26) configured to fixedly receive rails (50) along both sides of the magnets receiving portion (22) and an encoder scale support receiving portion (30) configured to fixedly receive an encoder scale support (40), wherein the encoder scale support receiving portion (30) comprises a plurality of decoupled tabs (31) mechanically decoupled from the rest of the magnetic track base (20) and arranged to receive a bottom side of the encoder scale support (40) to prevent, or at least reduce, deformation of the encoder scale support receiving portion (30) that may be caused from the deformation of the rest of the magnetic track base (20) when said track base (20) is subjected to external forces.

2. Magnetic track base (20) according to claim 1, wherein said plurality of decoupled tabs (31) comprises a corresponding plurality of fixation tabs (32) and decoupling members (38) for mechanical decoupling between each fixation tab (32) and the rest of the magnetic track base (20).

3. Magnetic track base (20) according to the preceding claim, wherein each decoupling member is a cut-out part arranged around a corresponding fixation tab (32).

4. Magnetic track base (20) according to the preceding claim, wherein said cut-out part is in the form of a U-shape through-groove extending from a top side (20a) to a bottom side (20b) of the magnetic track base (20).

5. Magnetic track base (20) according to any of claims 2 to 4, wherein each fixation tab (32) comprises a top flat surface (33) comprising a fixation hole (34), said surface (33) being raised above the surface of the magnetic receiving portion (22).

6. Magnetic track base (20) according to any of claim 2 to 5, wherein said plurality of fixation tabs (32) is arranged along a longitudinal direction between the magnetic receiving portion (22) and one rail receiving portion (26).

7. Magnetic track base (20) according to any preceding claim, wherein the magnetic receiving portion (22) comprises a plurality of pairs of threaded holes (25) for fixing permanent magnets (52) with screws and a plurality of pairs of through-holes (24) for fixing the magnetic track base (20) to a magnetic track base support.

8. Magnetic track base (20) according to the preceding claim, wherein the cut-out parts (38) each surrounds one through-hole of said pairs of through-holes (24) for fixing the magnetic track base (20) to the magnetic track base support in such a way that the fixation tabs (32) are rigidly fixed to said support.

9. Magnetic track base (20) according to any preceding claim, wherein said magnetic track base is monobloc.

10. Magnetic track base (20) according to any preceding claim, wherein the encoder scale support (40) has a predominantly constant L-shaped cross-section along the length of said support forming a stand (44) which is fixed onto the encoder scale support receiving portion (30).

11. A stationary part (10) of a linear motor, comprising the magnetic track base (20) according to any preceding claim, magnets (52) fixed to the magnetic receiving portion (22), rails (50) fixed on rail receiving portions on both sides of the magnets (52), an encoder scale support (40) fixed to the encoder scale support receiving portion (30) and an encoder scale fixed to the encoder scale support (40).

12. A linear motor comprising the stationary part (10) according to the preceding claim, and a mobile part (70) comprising a coil assembly (60), sliders (62) slidably engaged with respective rails (50) of the stationary part (10) and an optical reader (64) arranged to move along the encoder scale.

13. A motion-positioning system, in particular a wafer positioning system, comprising at least one linear motor according to the preceding claim.
